# EUROPEAN PATENT APPLICATION

(11) **EP 4 528 938 A1**
(43) Date of publication of application: **26.03.2025**
(21) Application number: 23829393.0
(22) Date of filing: 13.02.2023
(51) Int. Cl.: H01R 13/24

(54) **TERMINAL, CONNECTOR, AND ELECTRONIC DEVICE**

(30) Priority: 28.06.2022 CN 202210742193
(71) Applicant: ZTE Corporation, Shenzhen, Guangdong 518057 (CN)
(72) Inventor: LI, Dongtian, Shenzhen, Guangdong 518057 (CN); LIU, Xiang, Shenzhen, Guangdong 518057 (CN)
(74) Representative: Ziebig Hengelhaupt Intellectual Property Attorneys Patentanwaltskanzlei PartGmbB
(86) International application number: PCT/CN2023/075763
(87) International publication number: WO 2024/001200

(57) **Abstract**

The present application provides a terminal, a connector, and an electronic device. The terminal comprises: a first connection end (101) configured to be connected to a bonding pad in a circuit board (106); a second connection end (102) configured to be connected to a bonding pad in a chip (107); and a terminal body configured to connect the first connection end (101) and the second connection end (102). The terminal body comprises a connection arm communicated with the first connection end (101) and the second connection end (102); the connection arm is elastically deformable and is provided with a first connection portion (103) and a second connection portion (104); when the connection arm elastically deforms, the first connection portion (103) is in contact with the second connection portion (104) to enable the first connection end (101) to be communicated with the second connection end (102), that is to say, when the connection arm elastically deforms, under the condition that the connection arm forms a signal transmission path for enabling the first connection end (101) to be communicated with the second connection end (102), the first connection portion (103) and the second connection portion (104) further form the other signal transmission path for enabling the first connection end (101) to be communicated with the second connection end (102). The structure can reduce the self-inductance of the terminal, so that the resonant frequency of the terminal is increased, thereby improving the bandwidth of signal transmission.

## Description

### CROSS REFERENCE TO RELATED APPLICATION

The present application is based on and claims priority to Chinese Patent Application No. 202210742193.2, filed on June 28, 2022, the entire contents of which are incorporated herein by reference.

### TECHNICAL FIELD

The present application relates to the field of electronic technology, and in particular to a terminal, a connector, and an electronic device.

### BACKGROUND

At present, for highly densely designed integrated circuit chips such as central processing units, grid arrays, spherical grid arrays, or planar grid arrays are generally used for packaging, so as to achieve the objective of being light, thin, short and small. In the process of product development, if integrated circuit chips such as central processing units are directly soldered onto a circuit board, it is unlikely to flexibly replace these integrated circuit chips according to development requirements. In order to solve this problem, it is proposed in some cases to connect an integrated circuit chip and a circuit board by means of a connector. By disposing a conductive terminal in a connector, when an integrated circuit chip is placed in the connector, the pins of the integrated circuit chip can be electrically connected to a circuit board via the conductive terminal, when it is necessary to replace the integrated circuit chip, the original integrated circuit chip can be removed from the connector and a new integrated circuit chip can be placed.

In some cases, although a conductive terminal in a connector can enable the electrical connection between an integrated circuit chip and a circuit board, there is only one signal transmission path in the conductive terminal, and there is strong self-inductance in the conductive terminal, thereby leading to low-frequency resonance, and limit to the bandwidth of signal transmission.

### SUMMARY

The embodiments of the present application provide a terminal, a connector, and an electronic device.

In a first aspect, the embodiments of the present application provide a terminal, comprising: a first connection end configured to be connected to a bonding pad in a circuit board; a second connection end configured to be connected to a bonding pad in a chip; and a terminal body configured to connect the first connection end and the second connection end; the terminal body includes a connection arm communicated with the first connection end and the second connection end, the connection arm is elastically deformable and is provided with a first connection portion and a second connection portion, when the connection arm elastically deforms, the first connection portion is in contact with the second connection portion to enable the first connection end to be communicated with the second connection end.

In a second aspect, the embodiments of the present application further provide a connector, provided with a terminal accommodating groove, and the terminal accommodating groove is internally provided with the terminal according to the first aspect.

In a third aspect, the embodiments of the present application further provide an electronic device comprising the connector according to the second aspect.

### BRIEF DESCRIPTION OF DRAWINGS

FIG. 1 is a schematic structural diagram of a terminal before elastic deformation of a connection arm provided by one embodiment of the present application;
FIG. 2 is a schematic structural diagram of a terminal after elastic deformation of a connection arm provided by one embodiment of the present application;
FIG. 3 is a schematic structural diagram of a terminal provided by another embodiment of the present application;
FIG. 4 is a schematic structural diagram of a terminal in some cases;
FIG. 5 is a schematic structural diagram of a terminal provided by another embodiment of the present application;
FIG. 6 is a schematic structural diagram of a terminal before elastic deformation of a connection arm provided by another embodiment of the present application;
FIG. 7 is a schematic structural diagram of a terminal after elastic deformation of a connection arm provided by another embodiment of the present application;
FIG. 8 is a schematic structural diagram of a terminal after elastic deformation of a connection arm provided by another embodiment of the present application;
FIG. 9 is a schematic diagram of simulation results of insertion loss provided by one embodiment of the present application;
FIG. 10 is a schematic diagram of simulation results of return loss provided by one embodiment of the present application;
FIG. 11 is a schematic diagram of simulation results of a time-domain reflectometer provided by one embodiment of the present application;
FIG. 12 is a schematic diagram of simulation results of crosstalk between signal pairs provided by one embodiment of the present application;
FIG. 13 is a schematic structural diagram of a plastic body provided by one embodiment of the present application;
FIG. 14 is an enlarged partial view of point A in FIG. 13; and
FIG. 15 is a schematic structural diagram of a connector provided by one embodiment of the present application.

### DETAILED DESCRIPTION

In order to make the objects, technical solutions and advantages of the present application more clearly, the present application will be further illustrated in detail below in conjunction with the accompanying drawings and embodiments. It should be understood that the specific embodiments described here are merely used to illustrate the present application, but not intended to limit the present application.

It should be noted that although a logical sequence is shown in a flow chart, in some cases, the steps shown or described can be performed in a sequence different from that in the flowchart. In the specification, claims, and description of accompanying drawings, the meaning of a plurality of (or a number of) refers to two or more, greater than, less than, exceeding, etc., is to be understood as exclusive, and above, below, within, etc., is to be understood as inclusive. As used herein, the expression such as "first", "second", are used for the purpose of distinguishing between different technical features, it cannot be understood as indicating or implying relative importance, or implicitly indicating the number of the technical features indicated or implicitly indicating the precedence relationship of the technical features indicated.

The present application provides a terminal, a connector, and an electronic device, by disposing an elastically deformable connection arm that is used to be communicated with a first connection end and a second connection end, and disposing a first connection portion and a second connection portion on the connection arm, when the connection arm elastically deforms, the first connection portion is in contact with the second connection portion to enable the first connection end to be communicated with the second connection end, at this point, under the condition that the connection arm forms one signal transmission path for enabling the first connection end to be communicated with the second connection end, the first connection portion and the second connection portion further form the other signal transmission path for enabling the first connection end to be communicated with the second connection end. Therefore, the self-inductance of the terminal can be reduced, so that the resonant frequency of the terminal is increased, thereby improving the bandwidth of signal transmission.

The embodiments of the present application will be further described below in conjunction with the accompanying drawings.

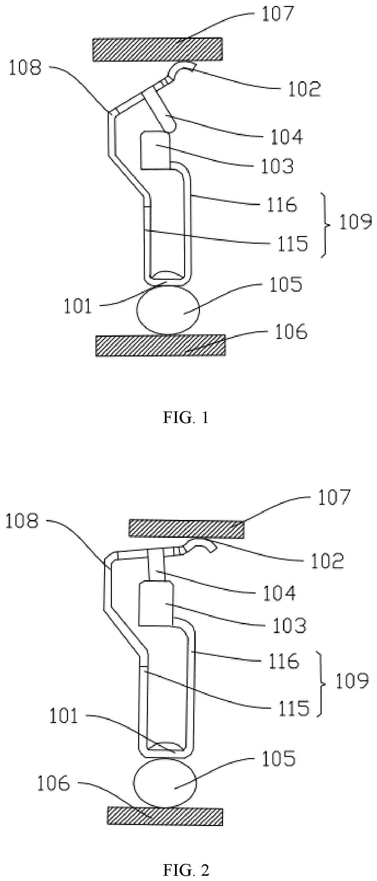

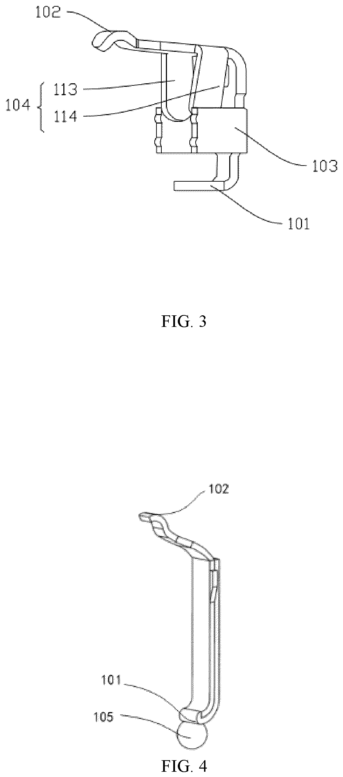

Referring to FIG. 1, FIG. 1 is a schematic structural diagram of a terminal provided by one embodiment of the present application. The terminal includes a first connection end 101, a second connection end 102 and a terminal body (not shown in the figure), wherein the first connection end 101 is configured to be connected to a bonding pad in a circuit board 106, the second connection end 102 is configured to be connected to a bonding pad in a chip 107, the terminal body is configured to connect the first connection end 101 and the second connection end 102, and the terminal body includes a connection arm (not shown in the figure) communicated with the first connection end 101 and the second connection end 102, the connection arm is elastically deformable and is provided with a first connection portion 103 and a second connection portion 104. Referring to FIG. 2, when the connection arm elastically deforms, the first connection portion 103 is in contact with the second connection portion 104 to enable the first connection end 101 to be communicated with the second connection end 102. Additionally, FIG. 3 is another schematic structural diagram of the terminal.

In this embodiment, by disposing an elastically deformable connection arm that is configured to be communicated with a first connection end 101 and a second connection end 102, and disposing a first connection portion 103 and a second connection portion 104 on the connection arm, when the connection arm elastically deforms, the first connection portion 103 is in contact with the second connection portion 104 to enable the first connection end 101 to be communicated with the second connection end 102, at this point, under the condition that the connection arm forms one signal transmission path for enabling the first connection end 101 to be communicated with the second connection end 102, the first connection portion 103 and the second connection portion 104 further form the other signal transmission path for enabling the first connection end 101 to be communicated with the second connection end 102. Compared with the terminal in some cases with only one signal transmission path therein (as shown in FIG. 4), there is one more signal transmission path in the terminal in the embodiments of the present application. Therefore, in the embodiments of the present application, the self-inductance of the terminal can be reduced, so that the resonant frequency of the terminal is increased, thereby improving the bandwidth of signal transmission.

It can be understood that a signal in the chip 107 can enter from the second connection end 102, flow through two elastically deformable connection arms, then flow out of the first connection end 101, and finally reach the circuit board 106, thereby enabling the electrical connection between the chip 107 and the circuit board 106.

It can be understood that signals are unevenly distributed on the terminal, with a large amount of signal gathering on the surface of the terminal, while the closer to the center of the terminal, the fewer signals there being, which is called the skin effect.

In one embodiment, the first connection end 101 can be connected to the bonding pad in the circuit board 106 by a conductive material, where the conductive material may be conductive rubber, conductive silver glue, solder balls, or metal springs, etc., and no specific limitation is made here. For example, as shown in FIG. 1, the first connection end 101 is connected to the bonding pad in the circuit board 106 by solder balls 105.

In one embodiment, the height of the terminal may be below 1.5 mm (millimeter), such as 1.5 mm, 1.3 mm, or other values, and no specific limitation is made here.

In one embodiment, the shape and dimension of the first connection end 101 and the shape and dimension of the second connection end 102 are not limited and can be set according to actual conditions. Where, each of the shape of the first connection end 101 and the shape of the second connection end 102 may be a smooth arc, a smooth circular arc, a smooth plane or other shapes, so as to reduce the sliding friction force generated when the second connection end 102 is in contact with the bonding pad in the chip 107, thereby reducing damage to the second connection end 102 and the bonding pad in the chip 107, and ensuring the stability of the electrical connection. In addition, both the dimension of the first connection end 101 and the dimension of the second connection end 102 correspond to the dimension of the terminal, and no specific limitation is made here.

In one embodiment, both the first connection portion 103 and the second connection portion 104 may be in block, sheet, or other shapes, and the first connection portion 103 may be in contact with the second connection portion 104 by snap-fitting, mortise-and-tenon, or other means. For example, when the first connection portion 103 and the second connection portion 104 are in contact by means of mortise-and-tenon, the first connection portion 103 can be a block provided with a groove, whereas the second connection portion 104 is a boss for matching the groove, and no specific limitation is made here.

In one embodiment, there can be various ways of the connection between the first connection end 101 and the bonding pad in the circuit board 106, and there can be various ways of the connection between the second connection end 102 and the bonding pad in the chip 107, such as bonding (such as laser bonding) or injection molding, etc., and no specific limitation is made here.

Based on the previous embodiment, referring to FIG. 1, the connection arm may comprise a connection arm body 109 and a connection suspending arm 108, where the first connection end 101 is disposed on the connection arm body 109, and the second connection end 102 is disposed on the connection suspending arm 108, when the connection arm elastically deforms, the connection suspending arm 108 is displaced relative to the connection arm body 109, until the first connection portion 103 on the connection arm is in contact with the second connection portion 104 on the connection arm to enable the first connection end 101 to be communicated with the second connection end 102, thereby forming the other signal transmission path for enabling the first connection end 101 to be communicated with the second connection end 102. Therefore, under the condition that the connection arm forms one signal transmission path for enabling the first connection end 101 to be communicated with the second connection end 102, the embodiments of the present application can form two signal transmission paths for enabling the first connection end 101 to be communicated with the second connection end 102, which can reduce the self-inductance of the terminal, so that the resonant frequency of the terminal is increased, thereby improving the bandwidth of signal transmission.

When the connection arm elastically deforms, the connection suspending arm 108 is displaced relative to the connection arm body 109, and the second connection portion 104 moves towards the first connection portion 103 and is in contact with the first connection portion 103, thereby forming the other signal transmission path for enabling the first connection end 101 to be communicated with the second connection end 102.

It can be understood that the connection arm is sound in elasticity, therefore, the contact force between the second connection portion 104 and the first connection portion 103 is sound, which can ensure the stability of the electrical contact between the second connection portion 104 and the first connection portion 103.

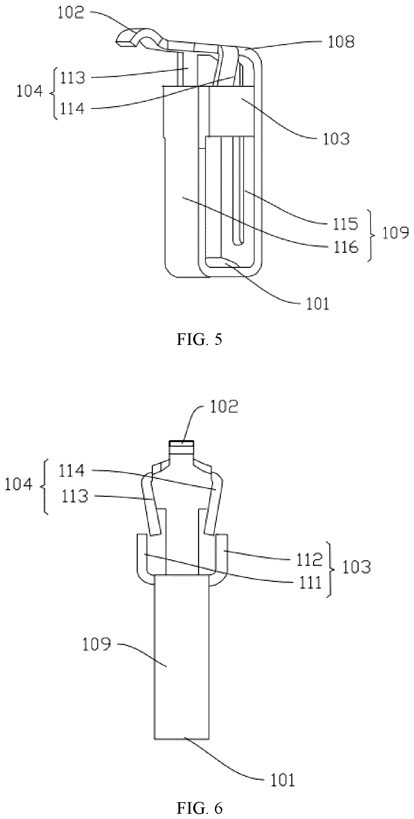

In one embodiment, referring to FIGS. 1 and 5, the connection arm body 109 is bent to form a first connection supporting arm 115 and a second connection supporting arm 116. The first connection supporting arm 115 is connected to the connection suspending arm 108, the first connection portion 103 is disposed on the second connection supporting arm 116, and the first connection end 101 is disposed at the transition region between the first connection supporting arm 115 and the second connection supporting arm 116, and no specific limitation is made here.

In one embodiment, the lengths of the connection suspending arm 108, the first connection supporting arm 115, and the second connection supporting arm 116 are not limited and can be set according to actual requirements.

Based on the previous embodiment, referring to FIGS. 1 and 5, the second connection supporting arm 116 and the first connection portion 103 form a surrounding structure, when the connection arm elastically deforms, the second connection portion 104 extends into the surrounding structure and is in contact with the first connection portion 103, so as to enable the first connection end 101 to be communicated with the second connection end 102, thereby forming the other signal transmission path for enabling the first connection end 101 to be communicated with the second connection end 102, which is not specifically limited in embodiments of the present application.

In one embodiment, referring to FIG.6, FIG.6 is a schematic structural diagram of the terminal before elastic deformation of a connection arm. The first connection portion 103 includes a first connection subportion 111 and a second connection subportion 112 that are disposed oppositely, and the second connection portion 104 includes a third connection subportion 113 and a fourth connection subportion 114 that are disposed oppositely. When the connection arm (not shown in the figure) elastically deforms, the first connection subportion 111 is in contact with the third connection subportion 113, and the second connection subportion 112 is in contact with the fourth connection subportion 114, so as to enable the first connection end 101 to be communicated with the second connection end 102, thereby forming the other signal transmission path for enabling the first connection end 101 to be communicated with the second connection end 102.

In one embodiment, the shape of the terminal is not limited to those shown in all figures above. Taking the cross section of the terminal as an example, the cross section of the terminal may have a shape of a polygon, such as a triangle, square, rectangle, diamond, trapezoid, or other shapes, which will not be enumerated here.

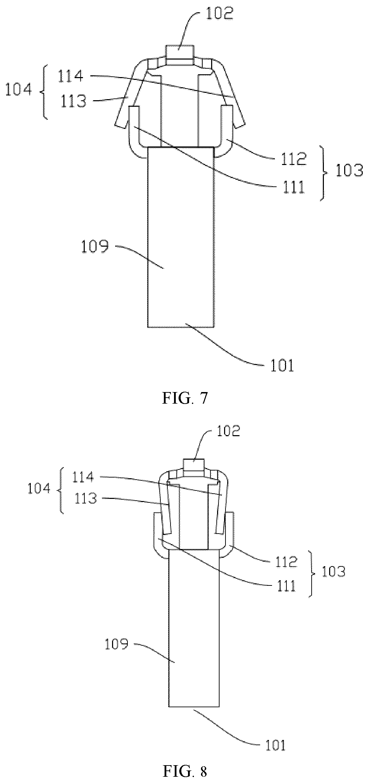

Based on the previous embodiment, when the first connection subportion 111 is in contact with the third connection subportion 113 and the second connection subportion 112 is in contact with the fourth connection subportion 114, both the third connection subportion 113 and the fourth connection subportion 114 are in the elastic deformation state. For example, referring to FIG. 7, when the third connection subportion 113 and the fourth connection subportion 114 are in the elastic deformation state, the third connection subportion 113 and the fourth connection subportion 114 move closer to each other; alternatively, referring to FIG. 8, when the third connection subportion 113 and the fourth connection subportion 114 are in the elastic deformation state, the third connection subportion 113 and the fourth connection subportion 114 move away from each other.

In one embodiment, the terminal can be integrally formed, that is, the terminal is made of only one material, which is a conductive material, and no specific limitation is made here.

Regarding the terminals provided in the above embodiments, the performance test results of a terminal with two signal transmission paths in the present application and a terminal with only one signal transmission path in some technical solutions will be described in detail below by examples in Test results I to IV.

### Test result I:

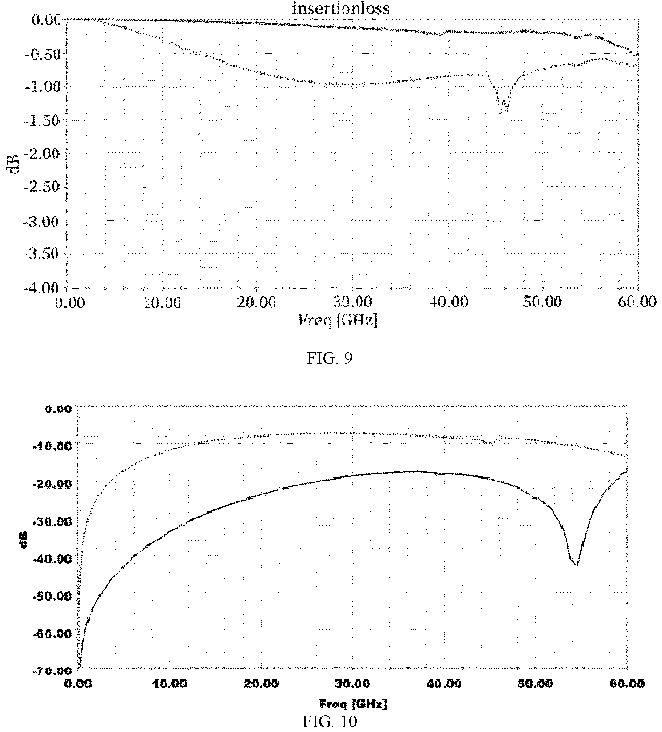

As shown in FIG. 9, the dashed line represents the insertion loss curve corresponding to one single signal transmission path, and the solid line represents the insertion loss curve corresponding to two signal transmission paths. As shown in FIG. 9, the insertion loss corresponding to two signal transmission paths is less than that corresponding to one single signal transmission path.

### Test result II:

As shown in FIG. 10, the dashed line represents the return loss curve corresponding to one single signal transmission path, and the solid line represents the return loss curve corresponding to two signal transmission paths. As shown in FIG. 10, in the frequency range of 0-60 GHz, the absolute value of the return loss corresponding to two signal transmission paths is larger than that corresponding to one single signal transmission path.

### Test result III:

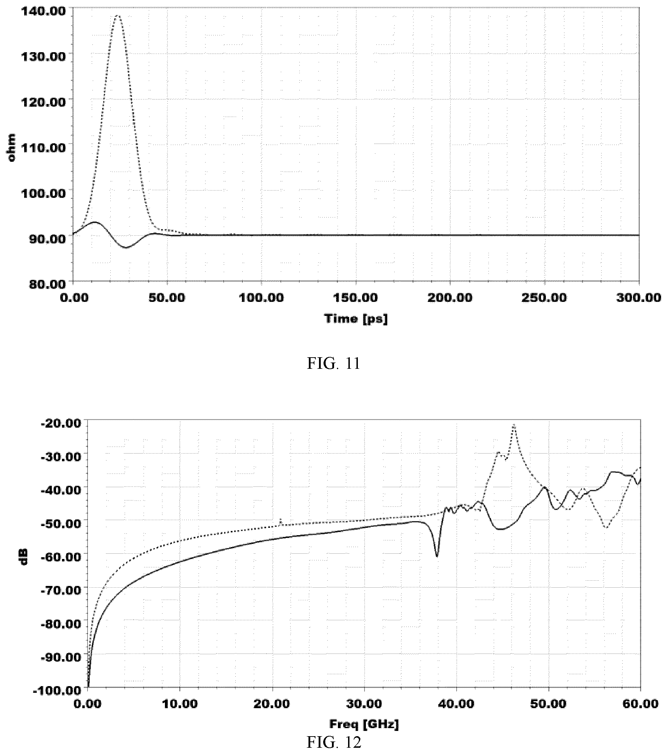

As shown in FIG. 11, the dashed line represents the TDR (Time-Domain Reflectometer) corresponding to one single signal transmission path, and the solid line represents the TDR corresponding to two signal transmission paths. As shown in FIG. 11, the horizontal axis represents time and the vertical axis represents impedance values. In the time range of 10-50 ps, the impedance value corresponding to two signal transmission paths is lower than that corresponding to one single signal transmission path; in the time range of 50-300 ps, the impedance value corresponding to two signal transmission paths is similar to that corresponding to one single signal transmission path.

### Test result IV:

As shown in FIG. 12, the dashed line represents the crosstalk between signal pairs corresponding to one single signal transmission path, and the solid line represents the crosstalk between signal pairs corresponding to two signal transmission paths. As shown in FIG. 12, the crosstalk between signal pairs corresponding to two signal transmission paths is smaller than that corresponding to one single signal transmission path. Therefore, the terminal of the present application can increase the shielding effect on the electromagnetic field and overcome the crosstalk between signal pairs.

Therefore, by comparing the insertion loss, return loss, TDR, and crosstalk between the terminal with two signal transmission paths and the terminal with one single signal transmission path, it can be concluded that the quality of signal transmission of the terminal with two signal transmission paths is higher than that of the terminal with one single signal transmission path.

In addition, another embodiment of the present application further provides a connector which is provided with a terminal accommodating groove, the terminal accommodating groove is internally provided with the terminal of any one of the preceding embodiments. The connector has the beneficial effects brought by the terminal of any one of the preceding embodiments. For example, in the terminal, by disposing an elastically deformable connection arm that is configured to be communicated with a first connection end and a second connection end, and disposing a first connection portion and a second connection portion on the connection arm, when the connection arm elastically deforms, the first connection portion is in contact with the second connection portion to enable the first connection end to be communicated with the second connection end, at this point, under the condition that the connection arm forms one signal transmission path for enabling the first connection end to be communicated with the second connection end, the first connection portion and the second connection portion further form the other signal transmission path for enabling the first connection end to be communicated with the second connection end. Therefore, the self-inductance of the terminal can be reduced, so that the resonant frequency of the terminal is increased, thereby improving the bandwidth of signal transmission of the terminal, which improves the bandwidth of signal transmission of the connector.

It can be understood that the assembly of each terminal and the terminal accommodating groove can enable interference fit.

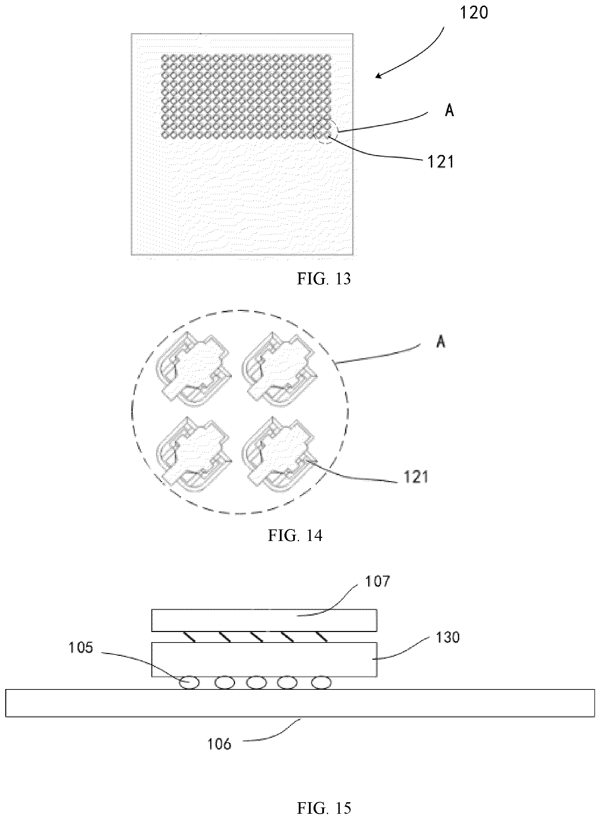

In one embodiment, as shown in FIGS. 13 and 14, the connector further includes a plastic housing 120 (HSG), the plastic housing 120 is provided with a terminal accommodating groove 121, and no specific limitation is made here.

In one embodiment, the speed of signal transmission of the terminal can be 112 Gbps, or 224 Gbps, or higher, and no specific limitation is made here.

In one embodiment, the terminal can be disposed on a connector at the signal transmission speed of 112 Gbps, 224 Gbps or higher, wherein the connector may be a CPU (Central Processing Unit) Socket, CPO (Co-packaging optical) Socket, CPC (Co packaging cable) Socket, NPC (Near Packaging cable) Socket or other connectors, no specific limitation is made here.

In one embodiment, as shown in FIG. 15, the connector 130 may be soldered to the circuit board 106 by solder balls 105, and the chip 107 may be connected to contacts (i.e. the second connection end) of the connector, so as to dismount the chip 107 conveniently, no specific limitation is made here.

In one embodiment, the shape of the terminal accommodating groove may be various, and the shape of the terminal accommodating groove is adapted to the shape of the terminal. Taking the cross section of the terminal accommodating groove as an example, the cross section of the terminal may have a shape of a polygon, such as a triangle, square, rectangle, diamond, or other shapes, which will not be enumerated here.

In addition, one embodiment of the present application further provides an electronic device comprising the connector of the preceding embodiments, the connector is provided with a terminal accommodating groove, the terminal accommodating groove is internally provided with the terminal of any one of the preceding embodiments. Therefore, the electronic device has the beneficial effects brought by the terminal of any one of the preceding embodiments, that is, in this terminal, by disposing an elastically deformable connection arm that is configured to be communicated with a first connection end and a second connection end, and disposing a first connection portion and a second connection portion on the connection arm, when the connection arm elastically deforms, the first connection portion is in contact with the second connection portion to enable the first connection end to be communicated with the second connection end, at this point, under the condition that the connection arm forms one signal transmission path for enabling the first connection end to be communicated with the second connection end, the first connection portion and the second connection portion further form the other signal transmission path for enabling the first connection end to be communicated with the second connection end. Therefore, the self-inductance of the terminal can be reduced, so that the resonant frequency of the terminal is increased, thereby improving the bandwidth of signal transmission of the terminal, which improves the bandwidth of signal transmission of the electronic device.

The embodiments of the present application include at least the following beneficial effects: by disposing an elastically deformable connection arm that is used to be communicated with a first connection end and a second connection end, and disposing a first connection portion and a second connection portion on the connection arm, when the connection arm elastically deforms, the first connection portion is in contact with the second connection portion to enable the first connection end to be communicated with the second connection end, at this point, under the condition that the connection arm forms one signal transmission path for enabling the first connection end to be communicated with the second connection end, the first connection portion and the second connection portion further form the other signal transmission path for enabling the first connection end to be communicated with the second connection end. Therefore, the self-inductance of the terminal can be reduced, so that the resonant frequency of the terminal is increased, thereby improving the bandwidth of signal transmission.

It is to be understood by those skilled in the art that all or some of the steps and systems in the methods disclosed above can be implemented as software, firmware, hardware, and suitable combination thereof. Some or all of the physical components can be implemented as software to be executed by a processor, such as a central processor, digital signal processor, or microprocessor, or as hardware, or as an integrated circuit, such as an application specific integrated circuit. Such software can be distributed on computer-readable media, which can include computer storage media (or non-transitory media) and communication media (or transitory media). As is well known to those skilled in the art, the term "computer storage media" includes volatile and nonvolatile, removable and non-removable media implemented in any method or technology for storage of information (such as computer readable instructions, data structures, program modules, or other data). Computer storage media includes, but is not limited to, RAM, ROM, EEPROM, flash memory or other memory technology, CD-ROM, digital versatile discs (DVD) or other optical disk storage, magnetic cassettes, magnetic tape, magnetic disk storage or other magnetic storage devices, or any other medium which can be used to store the desired information and is accessible by a computer. In addition, as is well known to those skilled in the art, communication media typically includes computer readable instructions, data structures, program modules, or other data in a modulated data signal such as a carrier wave or other transport mechanism, and can include any information delivery media.

## Claims

1. A terminal, comprising:
a first connection end configured to be connected to a bonding pad in a circuit board;
a second connection end configured to be connected to a bonding pad in a chip; and
a terminal body configured to connect the first connection end and the second connection end;
the terminal body comprising a connection arm communicated with the first connection end and the second connection end, the connection arm being elastically deformable and being provided with a first connection portion and a second connection portion, and upon the condition that the connection arm elastically deforms, the first connection portion being in contact with the second connection portion to enable the first connection end to be communicated with the second connection end.

2. The terminal according to claim 1, wherein the connection arm comprises a connection arm body and a connection suspending arm, the first connection end is disposed on the connection arm body, the second connection end is disposed on the connection suspending arm, and upon the condition that the connection arm elastically deforms, the connection suspending arm is displaced relative to the connection arm body.

3. The terminal according to claim 2, wherein the first connection end is disposed on the connection arm body, the second connection end is disposed on the connection suspending arm, and upon the condition that the connection arm elastically deforms, the second connection portion moves towards the first connection portion and is in contact with the first connection portion.

4. The terminal according to claim 1, wherein the first connection portion comprises a first connection subportion and a second connection subportion that are disposed oppositely, and the second connection portion comprises a third connection subportion and a fourth connection subportion that are disposed oppositely, and upon the condition that the connection arm elastically deforms, the first connection subportion is in contact with the third connection subportion, and the second connection subportion is in contact with the fourth connection subportion.

5. The terminal according to claim 4, wherein upon the condition that the first connection subportion is in contact with the third connection subportion and the second connection subportion is in contact with the fourth connection subportion, both the third connection subportion and the fourth connection subportion are in an elastic deformation state.

6. The terminal according to claim 5, wherein:
upon the condition that the third connection subportion and the fourth connection subportion are in the elastic deformation state, the third connection subportion and the fourth connection subportion move closer to each other;
alternatively,
upon the condition that the third connection subportion and the fourth connection subportion are in the elastic deformation state, the third connection subportion and the fourth connection subportion move away from each other.

7. The terminal according to claim 3, wherein the connection arm body is bent to form a first connection supporting arm and a second connection supporting arm, the first connection supporting arm is connected to the connection suspending arm, the first connection portion is disposed on the second connection supporting arm, and the first connection end is disposed at a transition region between the first connection supporting arm and the second connection supporting arm.

8. The terminal according to claim 7, wherein the second connection supporting arm and the first connection portion form a surrounding structure, and upon the condition that the connection arm elastically deforms, the second connection portion extends into the surrounding structure and is in contact with the first connection portion.

9. A connector, provided with a terminal accommodating groove, wherein the terminal accommodating groove is internally provided with the terminal according to any one of claims 1 to 8.

10. An electronic device, comprising the connector according to claim 9.
